Europäisches Patentamt

European Patent Office

Office européen des brevets

(19)

(11) Numéro de publication : **0 595 695 A1**

(12) **DEMANDE DE BREVET EUROPEEN**

(21) Numéro de dépôt : 93402598.2

(22) Date de dépôt : 22.10.93

(51) Int. Cl.⁵ : **G01S 15/89, G10K 11/34, H03C 1/00**

(30) Priorité : 26.10.92 FR 9212715

(43) Date de publication de la demande :
04.05.94 Bulletin 94/18

(84) Etats contractants désignés :
BE DE ES GB IT NL PT SE

(71) Demandeur : UNIVERSITE PIERRE ET MARIE
CURIE PARIS VI
4, place Jussieu
F-75252 Paris Cédex 05 (FR)

(72) Inventeur : **Alais, Pierre**
**17 Champromery**
**F-78720 Dampierre (FR)**

(74) Mandataire : **Fort, Jacques**
**CABINET PLASSERAUD 84, rue d'Amsterdam**
**F-75440 Paris Cedex 09 (FR)**

(54) **Dispositif de sondage ultrasonore à commande numérique de phase.**

(57) Le dispositif utilisable comme un sonar en milieu aqueux comprend un réseau de N transducteurs élémentaires d'ordre 1,..., i,..., N associés chacun à une voie d'émission ayant une mémoire numérique adressable (22) dont la sortie est reliée à un convertisseur numérique-analogique (34) d'attaque du transducteur respectif (Ti) et dont l'entrée d'adressage est reliée à un séquenceur, les séquenceurs des différentes voies étant prévus de façon à donner, aux signaux, des phases correspondant à une orientation $(\vec{\theta})$ et/ou une distance de focalisation (z)déterminées d'une cible. Certains seulement (A, B, C, D) des bits d'adresse de la mémoire numérique (22) sont fournis par un bus rapide (24) à la fréquence d'échantillonnage d'une période du signal, destiné à commander l'évolution temporelle sur des périodes successives, tandis que les autres bits, qui définissent le déphasage du signal, sont fournis par un bus lent (26) et modifiés uniquement en cas de changement d'orientation ou de distance de la cible.

FIG.2.

EP 0 595 695 A1

La présente invention concerne les dispositifs de sondage ultrasonore directif et à focalisation destinés à des applications où la résolution longitudinale requise permet de tolérer des durées de signaux représentant de plusieurs dizaines à plusieurs centaines de périodes.

Dans ce cas, l'approximation consistant à exciter les transducteurs d'un réseau par des signaux présentant des déphasages modulo $2\Pi$ plutôt que par des signaux décalés temporellement de façon à refléter exactement les différences de distance entre la cible et les transducteurs donne des résultats safisfaisants.

On connaît déjà de tels dispositifs du type comprenant un réseau de N transducteurs élémentaires d'ordre 1,..., i,..., N associés chacun à une voie d'émission ayant une mémoire numérique adressable dont la sortie est reliée à un convertisseur numérique-analogique d'attaque du transducteur respectif et dont l'entrée d'adressage est reliée à un séquenceur, les séquenceurs des différentes voies étant prévus de façon à donner aux signaux des phases correspondant à une orientation et/ou une distance de focalisation déterminées d'une cible.

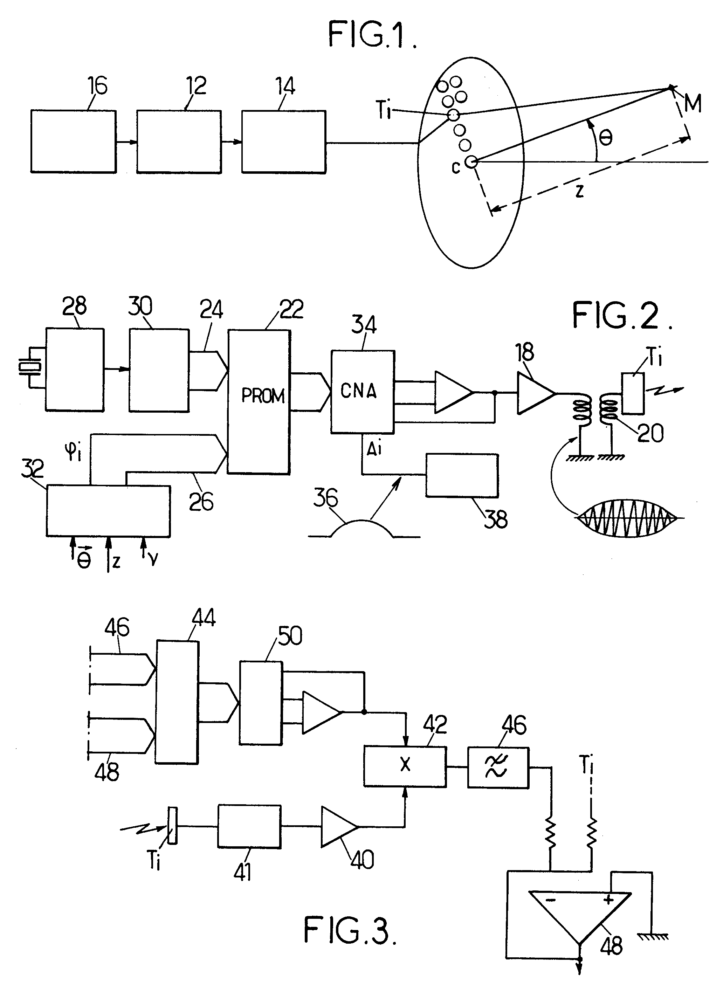

La figure 1 montre que le retard d'émission $\tau_i$ à utiliser pour un transducteur Ti, par rapport à un transducteur C pris comme référence, doit être, pour focaliser en un point M :

$$\tau_i = (1/c)(MTi - MC) \quad (1)$$

où c est la célérité des ondes dans le milieu.

Ce retard peut être simulé par des déphasages $\Phi i$ modulo $2\Pi$ donnés par :

$$\Phi i = (2\Pi\nu/c)(MTi - MC) \quad (2)$$

où $\nu$ est la fréquence ultrasonore.

Une opération symétrique peut être effectuée à la réception.

En principe, chaque voie peut avoir la constitution simple montrée en figure 1 et comporter une mémoire numérique 12 suivie d'un convertisseur numérique-analogique 14. La mémoire 12 contient des échantillons numérisés chacun sur un nombre de bits suffisant pour assurer la précision requise (8 bits par exemple), en nombre suffisant pour reconstituer un signal sinusoïdal. Un séquenceur d'adressage 16 sélectionne les échantillons dans l'ordre requis pour synthétiser un signal S de la forme :

$$S_i = Ai \sin[(2\Pi p/n) + \Phi i(\Theta, z)] \quad (3)$$

où z est la distance entre le transducteur de référence et la cible, n est le nombre d'échantillons par période du signal et p le numéro d'ordre de chaque échantillon.

En fait, ce dispositif n'est pas satisfaisant dans la pratique. Il exige en effet un adressage à fréquence très élevée caril faut au minimum n = 16 échantillons par période pour synthétiser correctement un signal et chaque changement d'un paramètre de désignation de la cible (angle $\Theta$ et/ou distance z) conduit à un déphasage différent, ce déphasage devant être lui-même réglable par fractions ne dépassant $2\Pi/n$. Au surplus, il se prête mal à l'apodisation du signal, qui se traduit par la nécessité d'une enveloppe qui n'est pas rectangulaire, mais à croissance et décroissance progressives (par exemple parabolique ou en cosinus surélevé).

L'invention vise à fournir un dispositif du type ci-dessus défini répondant mieux que ceux antérieurement connus aux exigences de la pratique, notamment en ce qu'il facilite l'adressage. Elle propose dans ce but un dispositif dans lequel certains seulement des bits d'adresse de la mémoire numérique sont fournis par un bus rapide, à la fréquence d'échantillonnage d'une période du signal, destiné à commander l'évolution temporelle sur des périodes successives, tandis que les autres bits, qui définissent le déphasage du signal, sont fournis par un bus lent et modifiés uniquement en cas de changement d'orientation ou de distance de la cible.

Le bus rapide peut comporter quatre bits seulement, l'évolution temporelle d'un signal sinusoïdal pouvant être représenté avec une période d'échantillonnage égale à 1/16ème de la période du signal.

Le signal sur le bus rapide peut être généré par simple comptage d'un signal d'horloge délivré par un oscillateur à fréquence fixe, lorsque le signal ultrasonore n'est pas modulé en fréquence. Mais le dispositif est aisément adaptable à une exploration avec modulation en fréquence, dans une bande qui reste limitée, mais autorise cependant un taux de compression appréciable. Dans ce cas, la fréquence de modification du mot (mot de quatre bits par exemple) sur le bus rapide doit varier. Pour cela, on peut utiliser un signal d'horloge fourni par un oscillateur à fréquence modifiée progressivement par un signal analogique (oscillateur à commande par tension par exemple). Une autre approche, mettant en oeuvre des moyens numériques, consiste à synthétiser la modulation de fréquence en appliquant au bus rapide un signal fourni par une mémoire programmable adressée par une horloge à quartz rapide et simulant l'évolution cyclique requise de la fréquence. L'utilisation d'une mémoire et d'une horloge à quartz rapide permet de commander numériquement la fréquence et, éventuellement, son évolution temporelle.

Le bus lent aura un nombre de bits suffisant pour définir la phase $\phi i$ à mieux que $2\Pi/n$, c'est-à-dire en général mieux que $2\Pi/16$. La correction de phase n'évolue en général que lentement en fonction du temps. Deux exemples d'applications particulièrement importants le montrent.

Lorsque l'invention est mise en oeuvre dans un sonar multifaisceaux séquentiel monté sur un navire, une stabilisation en roulis est fréquemment nécessaire. Le roulis correspond simplement à une modification périodique de l'angle Θ, la direction CM restant toujours dans un même plan. Classiquement, un tel sonar est souvent réalisé à l'aide d'un réseau de seize transducteurs. Dans ce cas, chaque Φi ne requiert que la connaissance de ν sin Θ. Cette information, numérisée sur sept bits, constitue le signal sur le bus lent, dont la période de répétition sera celle du roulis, toujours de plusieurs secondes.

Dans le cas d'un sonar latéral d'exploration, on recherche au contraire une focalisation dynamique, c'est-à-dire à des distances z variables, souvent pouvant prendre seize valeurs, donc avec définition sur quatre conducteurs de bit. En ajoutant cinq conducteurs de bit au bus lent, on peut effectuer une correction angulaire dans une plage de ± 4°, avec échantillonnage au quart de degré..

Comme on l'a indiqué plus haut, le dispositif de sondage peut comporter des moyens symétriques des précédents à la réception.

L'invention sera mieux comprise à la lecture de la description qui suit d'un mode particulier de réalisation, donné à titre d'exemple non limitatif, et de variantes. La description se réfère aux dessins qui l'accompagnent, dans lesquels :

- la figure 1, déjà mentionnée, montre les paramètres essentiels qui interviennent dans la réalisation d'un dispositif de sondage à commande numérique de phase ;
- la figure 2 est un synoptique simplifié montrant une constitution possible d'une voie d'émission ;
- la figure 3, similaire à la figure 2, montre une constitution possible d'une voie de réception ;
- la figure 4, similaire aux deux précédentes, montre une chaîne émettrice-réceptrice utilisable avec un même transducteur ;
- la figure 5 montre un dispositif de traitement numérique de corrélation utilisable dans la voie de réception de la figure 3 ou 4 ; et
- la figure 6, similaire à une fraction de la figure 4, indique des caractéristiques utilisables pour constituer un sonar multifaisceaux mettant en oeuvre l'invention.

On décrira tout d'abord, en faisant référence à la figure 2, une voie d'émission utilisable dans un dispositif de sondage ultrasonore ne comportant pas de modulation de fréquence. La voie d'émission comporte une unité de synthèse de signal, un amplificateur de puissance 18 et un transformateur 20 d'adaptation d'impédance à celle du transducteur Ti. L'unité de synthèse comporte une mémoire morte programmable et adressable 22 contenant des échantillons de signal, représentatifs de l'évolution temporelle du signal, pour une amplitude unique déterminée. L'entrée d'adressage est divisée en deux parties, attaquées respectivement par un bus rapide 24 et par un bus lent 26. Le bus rapide 24 fixe la fréquence de lecture des échantillons pour reconstituer l'évolution temporelle du signal. En général, un signal sinusoïdal peut être reconstitué de façon satisfaisante à partir de n = 16 échantillons. En conséquence, le bus rapide 24 attaquera alors quatre bits de l'entrée d'adresse, par exemple les bits de poids faible A, B, C, D. Les bus 24 de tous les transducteurs peuvent être attaqués par un même circuit de commande, comportant une horloge rapide 28 et un compteur 30 modulo n.

Le bus lent est destiné à la correction de phase permettant de focaliser à une distance déterminée z et dans la direction Θ.

Il est souhaitable que la phase Φi soit définie à mieux que 2Π/n, par exemple à 2Π/32 dans le cas où n = 16. L'information apportée par le bus 26 évolue en général lentement en fonction du temps, par exemple lors du changement de la profondeur de focalisation dans une direction donnée (variation de z) soit parce que la

direction $\vec{\Theta}$ change, ce qui est le cas d'une stabilisation en roulis et/ou en tanaaae du porteur du dispositif.

La correction Φi peut être élaborée par un calculateur 32 qui reçoit $\vec{\Theta}$ ,z et ν. La mémoire 22 doit dans ce cas avoir une capacité égale au produit du nombre de déphasages possibles par le nombre d'échantillons par période.

Dans une variante de réalisation, qui ne présente d'intérêt que lorsque le nombre de déphasages possibles est réduit et correspond aux variations d'un seul des paramètres $\vec{\Theta}$ ,z et ν, le bus 26 peut être prévu pour fournir directement à la mémoire morte un nombre représentatif de la valeur discrétisée du paramètre, sélectionnant un sous-ensemble des échantillons mémorisés.

On voit que le bus 24 apporte à la mémoire l'information correspondant au premier terme entre crochets de la formule (3) ci-dessus tandis que le bus lent 26 correspond au second terme ou terme corectif de phase.

La sortie de la mémoire morte 22 attaque un convertisseur numérique-analogique 34. Ce convertisseur peut être prévu pour recevoir un signal analogique de référence fourni par un générateur 38, sélectionné pour réaliser l'apodisation temporelle du signal d'émission en provoquant une variation du gain en fonction du temps, avec une courbe d'enveloppe du genre montré en 36.

Le signal de sortie analogique du convertisseur 34 constitue la synthèse du signal analogique à appliquer au transducteur Ti. Il est porté à un niveau convenable par l'amplificateur 18. Naturellement l'apodisation spatiale de l'ouverture constituée par les N transducteurs est contenue dans la programmation des mémoires 22 qui permet de varier les amplitudes Ai d'une voie d'émission à l'autre pour un même signal de référence délivré par le générateur 38.

La voie de réception associée à un transducteur Ti (les transducteurs-récepteurs pouvant être les mêmes que les transducteurs-émetteurs ou être différents) comporte, à partir du transducteur, un préamplificateur à faible bruit 40. Si les mêmes transducteurs sont utilisés à l'émission et à la réception, un circuit protecteur 41 est interposé entre le transducteur et le préamplificateur 40. Le signal de sortie du préamplificateur 40 est appliqué à un multiplieur 42 dont l'autre entrée reçoit un signal de référence de fréquence $\nu'$ distincte de la fréquence d'émission, synthétisé numériquement à partir des informations contenues dans une mémoire morte programmable 44 qui peut être la même que la mémoire 22 ou différente, ce second cas étant notamment celui où les transducteurs-récepteurs ont des emplacements différents de ceux des transducteurs-émetteurs. La mémoire morte 44 comporte elle aussi un bus rapide d'adressage 46 et un bus lent 48. Ce dernier fournit une adresse tenant compte de la phase compensatrice $\Phi i$ et élaborée dans un organe de calcul séparé. La phase compensatrice $\Phi i$ doit être calculée à la fréquence acoustique d'émission $\nu$. Le signal numérique provenant de la mémoire 44 est transformé en signal analogique par un convertisseur numérique-analogique 50. Un filtre passe-bas 46 placé sur la sortie du multiplieur 42 permet d'obtenir un signal Ii de courant à la fréquence décalée $\nu - \nu'$. Un amplificateur de courant 48 permet ensuite d'additionner les courants fournis par toutes les voies. La soustraction de fréquence impose d'inverser le signe de la phase compensatrice à la réception. La programmation des mémoires 44 permet de varier les amplitudes des intensités Ii d'une voie de réception à l'autre pour un même signal de réception afin de réaliser une apodisation spatiale à la réception.

Il est possible de combiner la voie d'émission et la voie de réception de façon à faire une utilisation commune de certains composants.

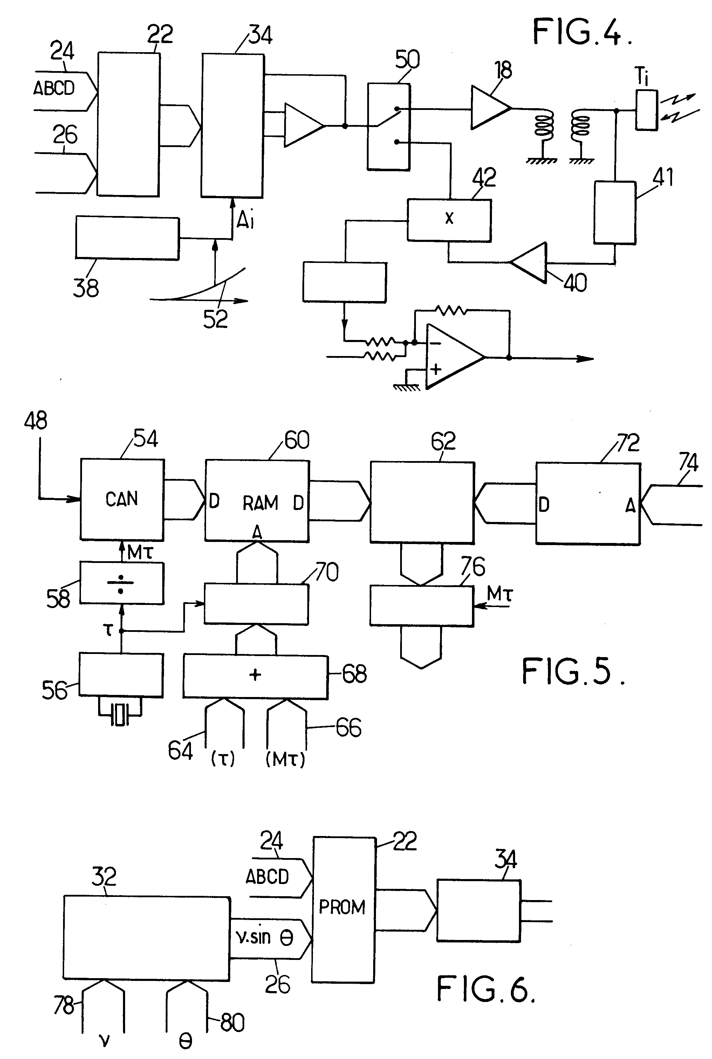

La figure 4, où les organes correspondant à ceux de la figure 2 portent le même numéro de référence, utilise l'unité de synthèse 24, 26, 22, 34 d'abord pour le signal d'émission, puis pour le signal de référence à la réception. Pour cela un commutateur analogique 50, commandé par un séquenceur dont le fonctionnement peut être provoqué par division du signal de l'horloge 28, envoie alternativement le signal d'émission synthétisé sur l'amplificateur 18, puis sur le multiplieur 42 de détection superhétérodyne au cours de la réception.

Dans le cas où l'unité de synthèse est utilisée d'une part à la réception, d'autre part à l'émission, le générateur 38 de signal de référence est prévu pour générer une enveloppe ayant la forme 36 montrée en figure 2 à l'émission, soit la forme 52 à la réception. La variation du gain en fonction du temps ainsi réalisé permet de compenser la diffraction et l'absorption dans le milieu de propagation. L'information fournie par le bus lent 26 correspond au déphasage direct $\Phi i$ à l'émission, à la phrase inverse $- \Phi i$ à la réception.

Comme on l'a indiqué plus haut, le dispositif peut être prévu pour émettre un signal de fréquence variable, tout en maintenant la collimation dans une direction fixe $\vec{\theta}$ ou une focalisation (z, $\vec{\Theta}$), en donnant à $\Phi i$ une valeur tenant compte de la fréquence instantanée $\nu(t) = d\Phi/dt$ du signal.

Toutefois, dans la mesure où le balancement de fréquence est faible par rapport à la fréquence centrale $\nu_0$ du signal, il est possible de conserver une valeur constante $\Phi i$, correspondant à la fréquence centrale.

Si l'erreur ainsi introduite se rapproche de $2\Pi/n$ ou même la dépasse, il devient nécessaire de tenir compte de l'évolution temporelle de $\nu$, d'augmenter le nombre d'échantillons numérisés et d'augmenter corrélativement le nombre de bits du bus lent 26 en vue de l'émission.

Un circuit de réception tel que celui représenté en figure 3 permet de recevoir un tel signal modulé en fréquence. Mais, en cas de réception superhétérodyne, la référence de fréquence $\nu'$ ne peut être compensée en phase qu'en tenant compte de la fréquence centrale $\nu_0$. La bande de fréquence utilisée doit être limitée, ainsi que l'ouverture, pour que l'erreur commise sur $\Phi i$ n'excède pas une fraction de période d'environ $2\Pi/n$.

On obtient encore un signal démodulé, dont la fréquence centrale est $\nu_0 - \nu'$, qui a la même largeur de bande que le signal initial.

Dans ce cas, il peut être utile d'effectuer sur le signal basse fréquence un traitement numérique en ligne de corrélation avec la réplique de l'émission, qui doit alors être également démodulée. Cette réplique peut être générée de façon précise et mémorisée.

Le traitement numérique peut être effectué à l'aide d'un dispositif du genre schématisé en figure 5. Le signal à basse fréquence provenant de l'amplificateur sommateur 48 est numérisé par un convertisseur 54 avec une période d'échantillonnage très supérieure à la fréquence de Shannon pour le signal basse fréquence. Le signal d'échantillonnage à période $\Delta t = M\tau$ peut être fourni, à partir d'une horloge 56 à fréquence $1/\tau$, par un diviseur 58 par M.

Le signal numérisé est stocké dans une mémoire vive de travail 60 capable de mémoriser les M mots les plus récents. Entre les opérations d'écriture, effectuées chacune en une période d'horloge $\tau$, les M - 1 mots précédents sont relus dans le temps disponible (M - 1)$\tau$ et envoyés à un multiplieur-accumulateur 62. La lecture en mémoire 60 est commandée par un bus rapide 64 à fréquence 1/$\tau$ et par un bus lent 66 à fréquence 1/M$\tau$. Les adresses se succédant à la période $\tau$ de l'horloge rapide 56 sont additionnées en 68 à l'adresse lente qui représente le déroulement du temps. Un registre 70 de sortie de l'additionneur 68 permet de lire le mot qui précède celui qui vient d'être écrit au temps (M - m)$\Delta$t.

Le multiplieur-accumulateur 62 reçoit également la sortie d'une mémoire morte programmable 72 contenant les échantillons successifs Sp = S(p$\Delta$t) de la réplique du signal d'émission démodulé, de fréquence $\nu_0$ - $\nu'$ et de structure connue. La lecture de la mémoire morte programmable 72 est commandée par un bus d'adresse 74 à la cadence d'apparition du signal d'émission démodulé.

Le multiplieur-accumulateur 62 fournit en conséquence, sur un registre de sortie 76 dans lequel la lecture et l'écriture s'effectuent à la cadence 1/M$\tau$ :

$$\sum_{m=1}^{m=M-1} R[t_i - (M-m)\Delta t] \cdot S(m\Delta t) \qquad (4)$$

On voit que la sortie constitue une valeur numérique approchée du produit d'intercorrélation du signal R(t) par la réplique du signal d'émission S(t), ce qui se traduit par un effet de compression, notamment pour un signal S(t) ayant une modulation linéaire de fréquence.

Si on charge, dans la mémoire 72, les termes $S'_p$ = S'(M-p$\Delta$t), on peut utiliser le même circuit pour traiter un signal R(t) de fréquence constante. Dans ce cas, on réalise un produit de convolution par un signal S'(t) de même fréquence, d'où un filtrage numérique passe bande que l'on peut régler par modification de la durée du signal S'(t). Le signal S'(t) est lui aussi de préférence apodisé temporellement suivant une loi similaire à celle du signal d'émission pour éviter les rebonds parasites du signal.

A titre d'exemple, pour un signal basse fréquence d'entrée à 1 kHz environ, on pourra adopter une période M$\tau$ de 32 $\mu$s, obtenue à partir d'une horloge à 8 MHz (c'est-à-dire pour $\tau$ = 125 ns). La mémoire vive 60 peut être prévue pour stocker M = 256 mots.

Parmi les applications possibles de l'invention, on peut citer la constitution d'un sonar multi-faisceaux séquentiel stabilisé contre le roulis. On peut notamment utiliser un réseau de seize transducteurs associés chacun à une voie d'émission et de réception du genre montré en figure 4. Une couverture angulaire de 32° symétrique par rapport à la verticale peut être obtenue au moyen de huit faisceaux de 4° stabilisés en roulis. La position angulaire du réseau de transducteurs peut être fournie par un inclinomètre à sortie numérique, sur un nombre de bits correspondant à la précision requise. Avec une représentation sur six bits, on peut obtenir une précision de 1° sur une plage complète de travail de 64°, permettant de compenser ± 16° en roulis, en conservant en permamence un champ angulaire de 32°.

Dans ce cas particulier, schématisé en figure 6, les valeurs de $\Phi$i à prendre en considération pour calculer les valeurs mémorisées dans la mémoire morte 22 ne requièrent que la connaissance de $\nu$ sin $\vec{\Theta}$. C'est cette information, numérisée sur sept bits par exemple, qui est fournie sur le bus lent 26. Elle peut être fournie par un générateur 32 constitué par une mémoire morte supplémentaire qui reçoit, sur quelques bits d'adresse 78 (8 par exemple) l'information $\nu$ et, sur les autres bits d'adresse (6 par exemple) l'information $\vec{\Theta}$ numérisée.

Un tel dispositif permet d'émettre à la demande soit un signal sinusoïdal de fréquence qui est constante pour un tir donné, mais peut varier d'un tir à l'autre dans une bande admissible pour l'antenne, soit un signal modulé en fréquence, qui permet d'améliorer le gain, toujours en restant dans une bande permettant une réception convenable par l'antenne contenant les transducteurs.

On a effectivement constitué un tel sonar multi-faisceaux émettant un signal de 8 ms à 100 kHz, avec modulation de fréquence sur une largeur de 4 kHz, permettant d'obtenir un taux de compression de 32, en mettant en oeuvre une antenne formée par un réseau phasé de transducteurs ayant vingt longueurs d'onde d'ouverture, destiné à constituer un sondeur de pêche. La capacité nécessaire pour la mémoire morte de chaque voie représente onze bits d'adresse, c'est-à-dire 2 K mots.

A titre d'exemple supplémentaire, on peut citer un sonar latéral autorisant une focalisation poursuite, c'est-à-dire autorisant la focalisation à des distances z différentes. Un tel sonar a été réalisé en définissant z sur quatre bits soit seize zones focales, avec une résolution latérale constante et une possibilité de réglage angulaire de $\Theta$ dans une plage de ± 4°, échantillonné au quart de degré à l'aide de cinq bits. La correction angulaire était prévue pour permettre de compenser les mouvements du porteur en lacet ou en tangage, mesurés par une centrale gyroscopique. Dans ce cas, les mémoires mortes 22 de chaque voie avaient treize bits d'adresse, dont quatre pour le bus rapide, ce qui se traduit par une capacité de 8 K mots.

## Revendications

1. Dispositif de sondage ultrasonore, directif et à focalisation, comprenant un réseau de N transducteurs élémentaires d'ordre 1,..., i,..., N associés chacun à une voie d'émission ayant une mémoire numérique adressable (22) dont la sortie est reliée à un convertisseur numérique-analogique (34) d'attaque du transducteur respectif (Ti) et dont l'entrée d'adressage est reliée à un séquenceur, les séquenceurs des différentes voies étant prévus de façon à donner, aux signaux, des phases correspondant à une orientation ( $\vec{\Theta}$ ) et/ou une distance de focalisation (z) déterminées d'une cible,
caractérisé en ce que certains seulement (A, B, C, D) des bits d'adresse de la mémoire numérique (22) sont fournis par un bus rapide (24) à la fréquence d'échantillonnage d'une période du signal, destiné à commander l'évolution temporelle sur des périodes successives, tandis que les autres bits, qui définissent le déphasage du signal, sont fournis par un bus lent (26) et modifiés uniquement en cas de changement d'orientation ou de distance de la cible.

2. Dispositif selon la revendication 1, caractérisé en ce que, le signal étant sensiblement sinusoïdal, la fréquence d'échantillonnage par le bus rapide est égale à seize fois la fréquence du signal.

3. Dispositif selon la revendication 1 ou 2, caractérisé en ce que le signal sur le bus rapide (24) est généré par comptage d'un signal d'horloge délivré par un oscillateur (28), à fréquence fixe ou commandé par tension.

4. Dispositif selon la revendication 1 ou 2, caractérisé en ce que le signal est modulé en fréquence par application au bus rapide (24) d'un signal fourni par une mémoire programmable adressée par une horloge à quartz rapide.

5. Dispositif selon l'une quelconque des revendications précédentes, caractérisé en ce que le bus lent (26) a un nombre de bits suffisant pour définir le déphasage ($\Phi i$) à mieux que $2\Pi/n$, où n est le nombre d'échantillons par période fournie par le bus rapide.

6. Dispositif selon l'une quelconque des revendications précédentes, caractérisé en ce que les bits de commande du déphasage appliqué au bus lent sont fournis par un calculateur (32) à partir d'informations représentant l'orientation et la distance de la cible.

7. Dispositif selon l'une quelconque des revendications précédentes, caractérisé en ce qu'il comporte des transducteurs de réception, pouvant être constitués par des transducteurs d'émission, associés chacun à une voie de réception comportant un multiplieur (42) qui reçoit un signal de référence représentatif du signal d'émission, synthétisé numériquement à partir du contenu de ladite mémoire numérique programmable (22) ou d'une mémoire programmable (44) supplémentaire, associée à un bus rapide (46) et un bus lent (48) fournissant respectivement une information d'échantillonnage sur une période et une information de déphasage.

8. Dispositif selon la revendication 7, dans lequel les transducteurs-récepteurs ont des emplacements différents de ceux des transducteurs-émetteurs, caractérisé en ce que le bus lent (48) associé à la mémoire numérique (44) de la voie de réception fournit une adresse tenant compte d'une phase compensatrice $\Phi i$.

9. Dispositif selon la revendication 7 ou 8, caractérisé en ce que la mémoire numérique (44) de la voie de réception et les bus d'adressage de cette mémoire sont prévus de façon à fournir une fréquence décalée de la fréquence du signal d'émission pour effectuer une détection superhétérodyne.

10. Dispositif selon la revendication 9, caractérisé en ce que la somme des signaux démodulés de réception provenant des différents transducteurs est soumise à un traitement numérique en ligne d'intercorrélation avec la réplique démodulée du signal d'émission.

11. Dispositif selon la revendication 10, caractérisé en ce que le traitement numérique est effectué par un ensemble comprenant : un convertisseur de numérisation du signal analogique représentant la somme des signaux démodulés de réception, avec une fréquence d'échantillonnage très supérieure à la fréquence de Shannon du signal démodulé à basse fréquence ; une mémoire vive de travail capable de mémoriser M mots provenant du convertisseur (54) ; des moyens de lecture en la mémoire de travail (60) et d'application des mots de sortie de la mémoire de travail à un multiplieur-accumulateur (62) qui reçoit également la sortie d'une mémoire morte programmable (72) contenant les échantillons successifs de la réplique du signal d'émission démodulé.

# FIG.1.

# FIG.2.

# FIG.3.

FIG.4.

FIG.5.

FIG.6.

Office européen
des brevets

**RAPPORT DE RECHERCHE EUROPEENNE**

Numero de la demande

EP 93 40 2598

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| A | FR-A-2 648 231 (ALAIS) 14 Décembre 1990<br><br>* page 10, ligne 15 - page 15, ligne 21; figures 2,4 *<br>--- | 1-3,7,9, 10 | G01S15/89<br>G10K11/34<br>H03C1/00 |
| A | 'Product Note 8791-3: Theory of Operation for the HP-8791 Models 7/10/11/21 Frequency Agile Signal Simulator' Mai 1992 , HEWLETT PACKARD , USA<br>* page 11; figures 2-6 *<br>* page 18 - page 26 *<br>--- | 1 | |
| A | EP-A-0 469 242 (ATLAS ELEKTRONIK) 5 Février 1992<br>* page 8, ligne 45 - page 9, ligne 15; figure 2 *<br>--- | 1 | |
| A | US-A-4 584 541 (NOSSEN) 22 Avril 1986<br>* colonne 3, ligne 51 - colonne 6, ligne 12; figures 3,6,8,11,12 *<br>--- | 1 | |
| A | DE-A-37 16 064 (LICENTIA) 24 Novembre 1988<br>* colonne 3, ligne 19 - ligne 36; figure 1 *<br>----- | 1 | **DOMAINES TECHNIQUES RECHERCHES (Int.Cl.5)**<br><br>G01S<br>G10K<br>H03C |

Le présent rapport a été établi pour toutes les revendications

| Lieu de la recherche | Date d'achèvement de la recherche | Examinateur |
|---|---|---|
| LA HAYE | 15 Décembre 1993 | Zaccà, F |